# EUROPÄISCHE PATENTSCHRIFT

(11) **EP 2 991 189 B1**
(45) Veröffentlichungstag und Bekanntmachung des Hinweises auf die Patenterteilung: **10.01.2018**
(21) Anmeldenummer: 15002481.8
(22) Anmeldetag: 21.08.2015
(51) Int. Cl.: H02J 7/00, H05K 7/20

(54) **LADEGERÄT FÜR EINEN AKKUPACK**
CHARGER FOR A BATTERY PACK
CHARGEUR DE BATTERIE

(30) Priorität: 29.08.2014 DE 102014012869
(43) Veröffentlichungstag der Anmeldung: 02.03.2016
(73) Patentinhaber: Andreas Stihl AG & Co. KG, 71336 Waiblingen (DE)
(72) Erfinder: KOCH, Friedhelm, D-71573 Allmersbach im Tal (DE); LIEBHARD, Gernot, D-71332 Waiblingen (DE); HEINRICH, Thomas, D-71397 Leutenbach (DE)
(74) Vertreter: Wasmuth, Rolf

(56) Entgegenhaltungen:
- EP-A1- 2 824 795
- CN-Y- 201 084 796
- JP-A- 2000 048 864
- US-A1- 2007 219 670

## Beschreibung

Die Erfindung betrifft ein Ladegerät für einen Akkupack nach dem Oberbegriff des Anspruchs 1.

Ein derartiges Ladegerät ist aus der EP-A 2 824 795 (Stand der Technik nach Artikel 54 (3) EPÜ) bekannt und besteht aus einem vorzugsweise geschlossenen Gehäuse sowie einer äußeren Ladeaufnahme für einen Akkupack. In der Ladeaufnahme - meist im Bereich einer Stirnwand - sind elektrische Verbindungskontakte zur elektrischen Kontaktierung eines einzusetzenden Akkupacks vorgesehen. Das Ladegerät ist mit einem elektrischen Anschluss für eine Versorgungsspannung ausgebildet, wobei zwischen dem elektrischen Anschluss und den Verbindungskontakten zum Akkupack eine Leistungselektronik angeordnet ist, über die der Akkupack elektrisch geladen wird.

Zur Abfuhr der beim Laden anfallenden Wärme ist im Gehäuse des Ladegerätes ein Kühlluftventilator angeordnet, dem über eine Zuluftöffnung als Saugluftstrom ein Kühlluftstrom als Akkuluftstrom durch den Akkupack zuströmt und über eine Abluftöffnung aus dem Gehäuse austritt.

Über eine weitere im Gehäuse ausgebildete Zuluftöffnung tritt aus der Gehäuseumgebung ein weiterer Kühlluftstrom in das Gehäuse ein, wobei der weitere Kühlluftstrom als vom Akkuluftstrom getrennter Saugluftstrom ausgebildet ist. Die Leistungselektronik liegt im Strömungsweg zwischen der weiteren Zuluftöffnung und dem Kühlluftventilator, wobei der weitere Kühlluftstrom nach Kühlung der Leistungselektronik dem Kühlluftventilator zugeführt ist.

Aus der CN 201084796 Y ist ein Ladegerät bekannt, bei dem über eine Zuluftöffnung ein den Akkupack durchströmender Akkuluftstrom als Kühlluftstrom zugeführt ist, der auch zur Kühlung der Bauteile der Leistungselektronik genutzt wird.

Die beim Aufladen der Einzelzellen im Akkupack anfallende Abwärme führt zu einer Temperaturerhöhung des Kühlluftstroms, so dass dieser beim Umströmen der Leistungselektronik eine nur noch geringe Wärmemenge aufnehmen und abführen kann. Die für eine Kühlung der Leistungselektronik notwendige Temperaturdifferenz zwischen dem Kühlluftstrom und den elektronischen Bauelementen der Leistungselektronik ist somit abhängig von der Temperaturerhöhung, die der Akkuluftstrom beim Durchströmen des Akkupacks erfährt.

Bei Schnellladegeräten oder Akkupacks großer Kapazität kann die Kühlung der Leistungselektronik unzureichend werden.

Der Erfindung liegt die Aufgabe zugrunde, ein Ladegerät für einen Akkupack derart weiterzubilden, dass einerseits ein den Akkupack ausreichend kühlender Akkuluftstrom gewährleistet ist und andererseits eine ausreichende Kühlung der Leistungselektronik sichergestellt ist.

Die Aufgabe wird erfindungsgemäß nach den kennzeichnenden Merkmalen des Anspruchs 1 gelöst.

Nach der Erfindung wird dem weiteren Kühlluftstrom über eine im Gehäuse ausgebildete, ergänzende Zuluftöffnung ein Teilluftstrom aus der Gehäuseumgebung zugeführt. Die Zuluftöffnung des weiteren Kühlluftstroms mündet oberhalb einer Platine der Leistungselektronik in den Gehäuseinnenraum, und die weitere Zuluftöffnung des Teilluftstroms mündet unterhalb der Platine der Leistungselektronik. Der weitere Kühlluftstrom mündet über eine im Gehäuse ausgebildete innere, z.B. fensterförmige Strömungsöffnung oder Aussparung in die Saugzone des Kühlluftventilators, wobei die innere Strömungsöffnung unmittelbar in die Saugzone des Kühlluftventilators münden kann. Dem weiteren Kühlluftstrom strömt über eine im Gehäuse ausgebildete, ergänzende Zuluftöffnung ein Teilluftstrom aus der Gehäuseumgebung zu.

Der in das Gehäuseinnere eintretende weitere Kühlluftstrom ist von dem Akkuluftstrom getrennt und daher von der Abwärme des Akkupacks nicht belastet, so dass eine ausreichend große Temperaturdifferenz zwischen dem weiteren Kühlluftstrom und den Leistungsbauteilen der Leistungselektronik gegeben ist, was eine intensive, wirksame Kühlung der Leistungselektronik sicherstellt. Von der Kühlung der Leistungselektronik getrennt wird der Akkuluftstrom durch den Akkupack gefördert, wobei der Kühlluftventilator sowohl den Akkuluftstrom als auch den weiteren Kühlluftstrom fördert.

Vorteilhaft sind beide Kühlluftströme, also der den Akkuluftstrom bildende Kühlluftstrom und der weitere Kühlluftstrom als räumlich voneinander getrennte Saugluftströme ausgebildet, die einem gemeinsamen Kühlluftventilator zugeführt sind. Dabei vereinen sich die Kühlluftströme über den Kühlluftventilator zu einem gemeinsamen Abluftstrom, werden also als gemeinsamer Abluftstrom aus dem Gehäuse ausgeblasen.

Die Strömungsöffnung ist in Strömungsrichtung des weiteren Kühlluftstroms nach der Leistungselektronik im Gehäuse vorgesehen, so dass die Leistungselektronik zwischen der Zuluftöffnung des weiteren Kühlluftstroms und der Strömungsöffnung liegt. Eine intensive, wirksame Kühlung der Leistungselektronik ist so sichergestellt.

Die Zuluftöffnung des weiteren Kühlluftstroms und die ergänzende Zuluftöffnung liegen auf verschiedenen Gehäuseseiten, vorzugsweise auf einander über Eck benachbarten Gehäuseseiten, wobei die Platine der Leistungselektronik in Draufsicht auf die Platine zwischen den Zuluftöffnungen und der inneren Strömungsöffnung zum Kühlluftventilator liegt.

Der Kühlluftventilator ist vorteilhaft unmittelbar vor der Abluftöffnung angeordnet, so dass der Kühlluftventilator nicht gegen einen Staudruck arbeiten muss. Auch bei kleinen Kühlluftventilatoren ist somit eine gute Förderwirkung gewährleistet.

Die Kühlluftströme im Ladegerät sind zweckmäßig in voneinander getrennten Gehäusekanälen geführt, so dass die Kühlluftströme bis zu ihrer Vereinigung auf der Saugseite des Kühlluftventilators voneinander räumlich unabhängig sind.

Weitere Merkmale der Erfindung ergeben sich aus den weiteren Ansprüchen, der Beschreibung und Zeichnung, in der nachstehend ein im Einzelnen beschriebenes Ausführungsbeispiel der Erfindung dargestellt ist. Es zeigen:
- Fig. 1: eine perspektivische Ansicht eines erfindungsgemäßen Ladegerätes,
- Fig. 2: einen schematischen Schnitt durch das Ladegerät längs der Linie II-II in Fig. 1,
- Fig. 3: einen schematischen Schnitt durch das Ladegerät längs der Linie III-III in Fig. 1,
- Fig. 4: eine Schnittdarstellung gemäß Fig. 3 mit einem in einer Ladeaufnahme des Ladegerätes eingelegten Akkupack,
- Fig. 5: einen Horizontalschnitt durch das Ladegerät nach Fig. 1,
- Fig. 6: in schematischer Darstellung die Unterschale des Ladegerätes nach Fig. 1,

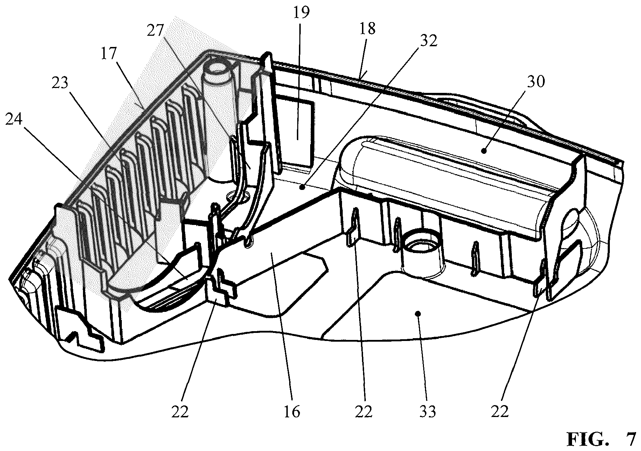

- Fig. 7: in vergrößerter Darstellung einen Gehäuseabschnitt der Unterschale nach Fig. 6 zur Aufnahme von Kühlluftventilatoren.

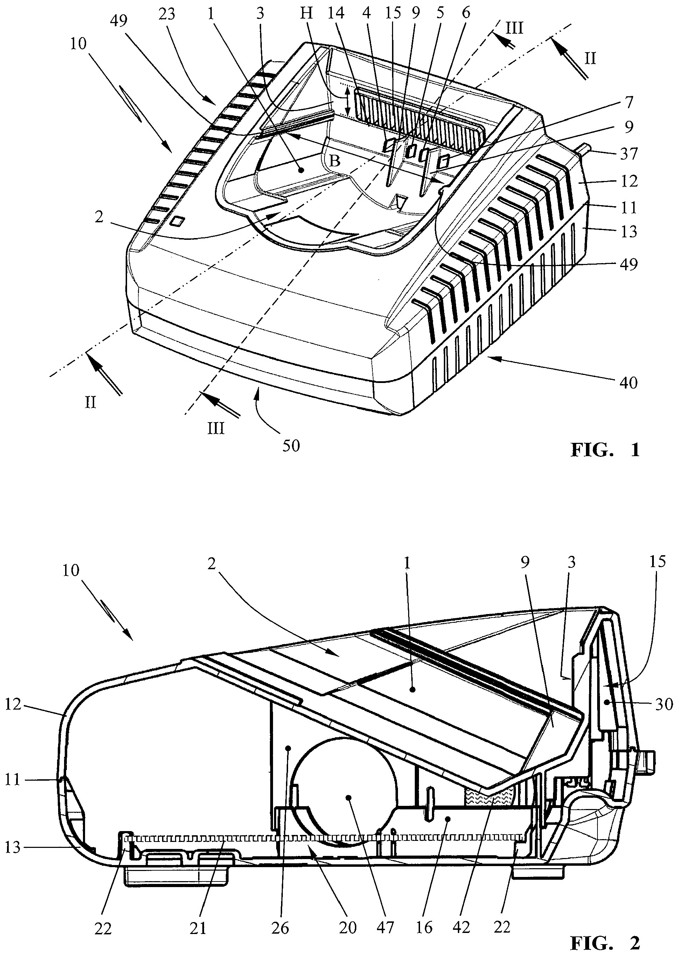

Das in Fig. 1 dargestellte Ladegerät 10 besteht aus einem Gehäuse 11, welches aus einer Oberschale 12 und einer Unterschale 13 zusammengesetzt ist. Das Gehäuse 11 des Ladegerätes 10 weist eine Ladeaufnahme 1 auf. Die Ladeaufnahme 1 ist - wie die Figuren 1 bis 4 zeigen - vorteilhaft nach Art einer Ladeschale 2 ausgebildet. Nachfolgend wird das Ladegerät 10 beispielhaft mit einer als Ladeschale 2 ausgebildeten Ladeaufnahme 1 beschrieben; andere Gestaltungen der Ladeaufnahme 1 können zweckmäßig sein, so z. B. ein Ladeschacht oder dgl.

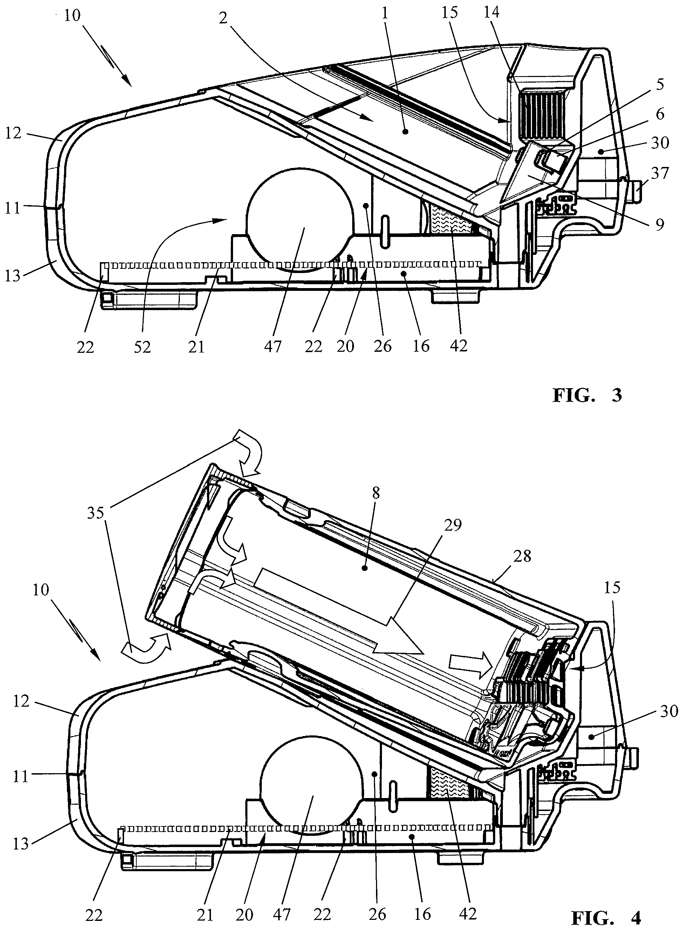

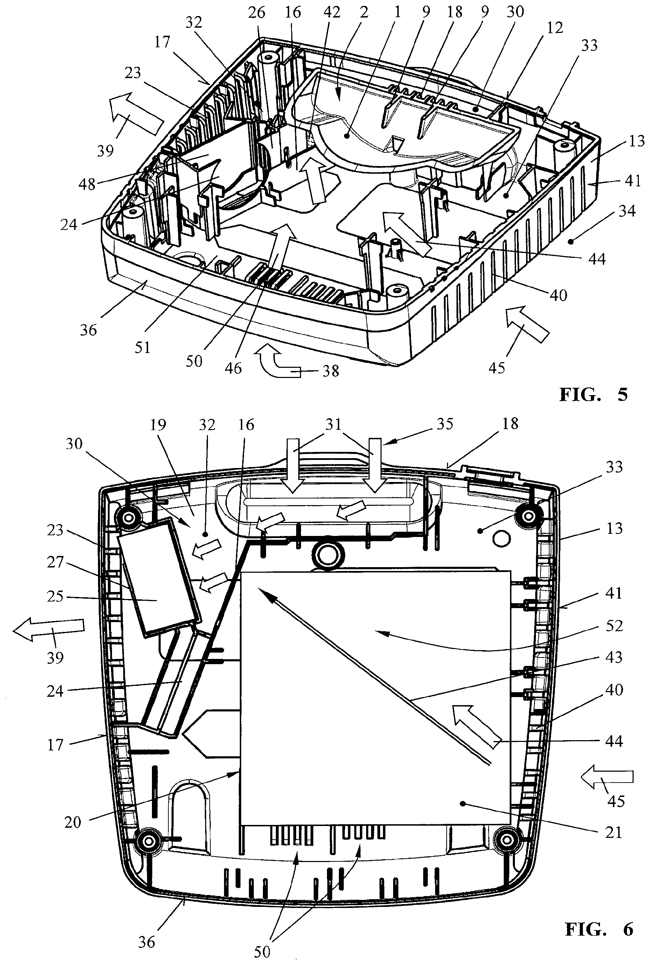

Im Stirnbereich 3 der Ladeaufnahme 1 sind elektrische Verbindungskontakte 4, 5, 6, 7 ausgebildet, die mit entsprechenden elektrischen Anschlüssen im Gehäuse 28 eines Akkupacks 8 (Fig. 4) zusammenwirken. Dabei bilden die äußeren elektrischen Verbindungskontakte 4, 7 Leistungskontakte, über die wieder aufladbare Zellen des Akkupacks 8 geladen werden. Zwischen den Verbindungskontakten 4, 7 liegen Verbindungskontakte 5, 6, die als Kommunikationskontakte ausgebildet sind. Über die Verbindungskontakte 5, 6 kommuniziert eine im Akkupack 8 angeordnete Schutzschaltung mit einer im Ladegerät 10 angeordneten Leistungselektronik (Fig. 6). Um eine räumliche Trennung der Leistung führenden Verbindungskontakte 4, 7 (Fig. 1) von den Kommunikationsdaten weiterleitenden Verbindungskontakten 5, 6 zu gewährleisten, sind in der Ladeaufnahme 2 Trennrippen 9 vorgesehen. Ein lagerichtiges Einlegen des Akkupacks 8 in die Ladeaufnahme 1 ist in nur einer vorgegebenen Position möglich, was durch seitliche Führungsrippen 49 in der Ladeaufnahme 1 vorgegeben ist. Am Akkupack 8 sind Führungsnuten angebracht, in die die Führungsrippen 49 eingreifen. Die Führungsnuten am Akkupack 8 sind außermittig angebracht, so dass der Akkupack in nur einer vorgegebenen Position eingeschoben werden kann, in der eine polrichtige Kontaktierung der Verbindungskontakte 4 bis 7 sichergestellt ist.

Im Stirnbereich 3 der Ladeaufnahme 1 ist ferner eine Zuluftöffnung 15 vorgesehen, die sich im gezeigten Ausführungsbeispiel über mehr als die Hälfte der Breite B der Ladeaufnahme 1 erstreckt. Die Höhe H der Zuluftöffnung 15 entspricht etwa der halben Höhe des Stirnbereichs 3, wobei die Zuluftöffnung 15 ein Zuluftgitter 14 aufweist.

Innerhalb des vorzugsweise weitgehend geschlossenen Gehäuses 11 des Ladegerätes 10 ist eine Leistungselektronik 20 vorgesehen. Die Platine 21 der Leistungselektronik 20 ist auf Trägern 22 in der Unterschale 13 gehalten. Die Leistungselektronik 20 steht über die Verbindungskontakte 4, 5, 6, 7 mit einem in der Ladeaufnahme 1 positionierten Akkupack 8 elektrisch in Verbindung; über einen elektrischen Anschluss 37 ist die Leistungselektronik 20 mit einer Versorgungsspannung verbunden.

Wie sich aus den Figuren 5 und 6 ergibt, ist in der Unterschale 13 eine Trennwand 16 ausgebildet, die etwa von der Mitte einer Seitenwand 17 zu einer Rückwand 18 verläuft. Die Trennwand 16 der Unterschale 13 wirkt mit einer Trennwand 26 (Fig. 2) der Oberschale 12 zusammen, derart, dass im Innenraum des geschlossenen Gehäuses 11 ein luftführender Gehäusekanal 30 ausgebildet ist. Die Trennwand 16 und die Trennwand 26 trennen - sich über ein Eck des Gehäuses 11 erstreckend - einen Teilraum 19 vom Gehäuseinnenraum 33 ab. Das Innere der Unterschale 13 und der Oberschale 12, also der Innenraum des Gehäuses 11, ist in zwei Teilbereiche aufgeteilt.

Dem im Innenraum des geschlossenen Gehäuses 11 ausgebildeten, luftführenden Gehäusekanal 30 strömt über die Zuluftöffnung 15 in dem Stirnbereich 3 der Ladeaufnahme 1 ein Saugluftstrom 35 (Fig. 6) zu. Der Saugluftstrom 35 wird von einem Akkuluftstrom 29 (Fig. 4) gebildet, der den Akkupack 8 durchströmt und als Kühlluftstrom 31 in den Gehäusekanal 30 eintritt. Über eine Abluftöffnung 23 in der Seitenwand 17 der Unterschale 13 wird der durch den Gehäusekanal 30 geführte Kühlluftstrom 31 abgeführt.

Zur Förderung des Saugluftstroms 35, der als Akkuluftstrom 29 durch die Zuluftöffnung 15 eintritt und als Kühlluftstrom 31 durch den Gehäusekanal 30 zur Abluftöffnung 23 strömt, ist ein Kühlluftventilator 25 vorgesehen. Ist ein Akkupack 8 in die Ladeaufnahme 1 eingelegt, kommuniziert die Zuluftöffnung 15 des Ladegerätes 10 unmittelbar mit einer Kühlluftöffnung im Gehäuse 28 des Akkupacks 8, so dass der den Akkupack 8 durchströmende Akkuluftstrom 29 unmittelbar über die Zuluftöffnung 15 in den Gehäusekanal 30 eintritt und als Kühlluftstrom 31 des Ladegerätes 10 über die Abluftöffnung 23 aus dem Gehäuse 11 des Ladegerätes 10 ausgeblasen wird.

Wie die Figuren 2 bis 6 zeigen, kann in der Trennwand 16 der Unterschale 13 eine Öffnung 47 ausgebildet sein, die von der Trennwand 26 der Oberschale 12 begrenzt wird. Die Öffnung 47 ist als Teil einer Aufnahme 24 für einen weiteren, optionalen Kühlluftventilator (nicht dargestellt) vorgesehen. Die Aufnahme 24 für den optionalen Kühlluftventilator und die Aufnahme 27 für den im Gehäusekanal 30 angeordneten Kühlluftventilator 25 liegen einander benachbart. Der in der Aufnahme 27 angeordnete Kühlluftventilator 25 und ein vorteilhaft in der Aufnahme 24 angeordneter, optionaler Kühlluftventilator blasen geförderte Kühlluft gemeinsam über die Abluftöffnung 23 im Gehäuse 11 aus. Die Aufnahme 24 für den optionalen Kühlluftventilator ist vom Gehäusekanal 30 getrennt vorgesehen, derart, dass die Saugseiten eines in der Aufnahme 24 angeordneten, optionalen Kühlluftventilators und eines in der Aufnahme 27 angeordneten Kühlluftventilators 25 voneinander räumlich getrennt sind. Der Gehäusekanal 30 führt ausschließlich den Kühlluftstrom 31 zum Kühlluftventilator 25, während die Aufnahme 24 ausschließlich mit dem Gehäuseinnenraum 33 in Verbindung steht. Im gezeigten Ausführungsbeispiel ist die Aufnahme 24 durch eine Sperrwand 48 der Oberschale 12 (Fig. 5) gegenüber der Abluftöffnung 23 luftdicht verschlossen, so dass der Gehäuseinnenraum 33 ausschließlich über eine fensterförmige Strömungsöffnung 42 mit einer Saugzone 32 des Kühlluftventilators 25 im Gehäusekanal 30 in Strömungsverbindung steht. Die Strömungsöffnung 42 ist im Ausführungsbeispiel als fensterförmige innere Strömungsöffnung 42 vorgesehen und vorzugsweise als Aussparung zweckmäßig in der Trennwand 26 der Oberschale 12 ausgebildet.

Nach der Erfindung ist im Gehäuse 11 eine weitere Zuluftöffnung 40 vorgesehen, die in den Gehäuseinnenraum 33 mündet. Die weitere Zuluftöffnung 40 ist vorzugsweise in der der Seitenwand 17 gegenüberliegenden Seitenwand 41 des Gehäuses 11 ausgebildet. Wie Fig. 6 zeigt, liegen die weitere Zuluftöffnung 40 und die Strömungsöffnung 42 einander etwa diagonal gegenüber. Die Strömungsöffnung 42 ist in der Seitenwand des Gehäusekanals 30 vorgesehen. Im Ausführungsbeispiel liegt die Strömungsöffnung 42 in der Trennwand 26 der Oberschale 12 des Gehäuses 11. Die Strömungsöffnung 42 mündet vorzugsweise unmittelbar in die Saugzone 32 des Kühlluftventilators 25. Die Querschnittsfläche der Strömungsöffnung 42 ist kleiner, bevorzugt mehr als die Hälfte kleiner ausgebildet als die Zuluftöffnung 15, über die der Saugluftstrom 35 als Kühlluftstrom 31 in den Gehäusekanal 30 eintritt. Im gezeigten Ausführungsbeispiel beträgt die Querschnittsfläche der Strömungsöffnung 42 weniger als ein Drittel der Querschnittsfläche der Zuluftöffnung 15.

Aufgrund der Strömungsöffnung 42 in der inneren Seitenwand des Gehäusekanals 30 wird - insbesondere als zusätzlicher Teilluftstrom - aus dem Gehäuseinnenraum 33 Luft abgesaugt. Im Gehäuseinnenraum 33 entsteht ein leichter Unterdruck. Zum Ausgleich des Unterdrucks strömt über die Zuluftöffnung 40 aus der Gehäuseumgebung 34 ein Saugluftstrom 45 ein. Dadurch bildet sich ein weiterer Kühlluftstrom 44 aus, der über die Zuluftöffnung 40 aus der Gehäuseumgebung 34 in den Gehäuseinnenraum 33 eintritt. Dieser weitere Kühlluftstrom 44 strömt über die Leistungselektronik 20 in Richtung auf die ergänzende Strömungsöffnung 42 und tritt durch die Strömungsöffnung 42 in den Gehäusekanal 30 ein. Die Strömungsöffnung 42 liegt mit geringem Abstand zur Rückwand 18 des Gehäuses 11, während die Zuluftöffnung 40 nahe der vorderen Stirnwand 36 des Gehäuses liegt. Dadurch ergibt sich ein Strömungsweg 43, der - in Draufsicht nach Fig. 6 auf die Platine 21 der Leistungselektronik 20 - etwa diagonal den Gehäuseinnenraum 33 durchläuft. Die Leistungselektronik 20 liegt somit im Strömungsweg 43 des weiteren Kühlluftstroms 44 zwischen der inneren Strömungsöffnung 42 und der äußeren Zuluftöffnung 40 im Gehäuse 11.

Der durch die Zuluftöffnung 40 in den Gehäuseinnenraum 33 eintretende weitere Kühlluftstrom 44 vereinigt sich nach Durchtritt durch die Strömungsöffnung 42 und Eintritt in den Gehäusekanal 30 mit dem über die Zuluftöffnung 15 eintretenden Kühlluftstrom 31. Die Saugluftströme 35 und 45 bzw. die Kühlluftströme 31 und 44 werden gemeinsam über den Kühlluftventilator 25 als gemeinsamer Abluftstrom 39 aus dem Gehäuse 11 abgeführt. Der Kühlluftventilator 25 liegt dabei vorteilhaft unmittelbar vor der Abluftöffnung 23.

Die räumlich voneinander getrennten Saugluftströme 35 und 45 werden als Kühlluftstrom 31 und weiterer Kühlluftstrom 44 dem gemeinsamen Kühlluftventilator 25 zugeführt. Dabei wird der erste Kühlluftstrom 31 in dem durch die Trennwände 16 und 26 begrenzten ersten Gehäusekanal 30 geführt. Der weitere Kühlluftstrom 44 wird im Gehäuseinnenraum 33 geführt, welcher einen vom ersten Gehäusekanal 30 strömungstechnisch getrennten zweiten Gehäusekanal 52 bildet.

In weiterer Ausgestaltung der Erfindung wird dem über die Zuluftöffnung 40 einströmenden weiteren Kühlluftstrom 44 ein Teilluftstrom 38 (Fig. 5) als ergänzender Kühlluftstrom 46 zugeführt. Der ergänzenden Kühlluftstrom 46 vereint sich im Gehäuseinnenraum 33 mit dem weiteren Kühlluftstrom 44. Die Vereinigung des Kühlluftstroms 44 mit dem ergänzende Kühlluftstrom 46 erfolgt vorteilhaft vor der inneren Strömungsöffnung 42, zweckmäßig spätestens beim Durchtritt durch die Strömungsöffnung 42. Der ergänzende Kühlluftstrom 46 strömt über eine im Gehäuse 11 ausgebildete, ergänzende Zuluftöffnung 50 als Teilluftstrom 38 aus der Gehäuseumgebung 34 in das Gehäuse 11 ein. Die Zuluftöffnung 40 des weiteren Kühlluftstroms 44 und die ergänzende Zuluftöffnung 50 des ergänzenden Kühlluftstroms 46 liegen vorzugsweise auf verschiedenen Gehäuseseiten. Im Ausführungsbeispiel liegen die Zuluftöffnung 40 und die ergänzende Zuluftöffnung 50 vorzugsweise auf einander über Eck benachbarten Gehäuseseiten, z. B. der Seitenwand 41 und der Stirnwand 36. Die Platine 21 der Leistungselektronik 20 liegt in Draufsicht auf die Platine 21 zwischen den Zuluftöffnungen 40, 50 und der inneren Strömungsöffnung 42 zur Saugzone 32 des Kühlluftventilators 25.

In vorteilhafter Ausbildung liegt die Zuluftöffnung 40 des weiteren Kühlluftstroms 44 oberhalb der Platine 21 der Leistungselektronik 20, während die ergänzende Zuluftöffnung 50 des ergänzenden Kühlluftstroms 46 unterhalb der Platine 21 der Leistungselektronik 20 in den Gehäuseinnenraum 33 mündet. Im Ausführungsbeispiel ist die ergänzende Zuluftöffnung 50 im Boden 51 der Unterschale ausgebildet, zweckmäßig benachbart zur vorderen Stirnwand 36.

## Patentansprüche

1. Ladegerät für einen Akkupack (8), bestehend aus einem Gehäuse (11), an dem eine Ladeaufnahme (1) mit äußeren Verbindungskontakten (4, 5, 6, 7) zur elektrischen Verbindung mit dem Akkupack (8) ausgebildet ist, mit einem elektrischen Anschluss (37) für eine Versorgungsspannung und mit einer zwischen dem elektrischen Anschluss (37) und den Verbindungskontakten (4, 5, 6, 7) angeordneten Leistungselektronik (20), mit einem im Gehäuse (11) angeordneten Kühlluftventilator (25) mit einem Kühlluftstrom (31), der als Saugluftstrom (35) über eine Zuluftöffnung (15) in das Gehäuse (11) eintritt und über eine Abluftöffnung (23) aus dem Gehäuse (11) austritt, wobei über die Zuluftöffnung (15) ein den Akkupack (8) durchströmender Akkuluftstrom (29) als Kühlluftstrom (31) zuströmt, und über eine weitere im Gehäuse (11) ausgebildete Zuluftöffnung (40) aus der Gehäuseumgebung (34) ein weiterer Saugluftstrom (45) in das Gehäuse (11) eintritt, wobei der weitere Saugluftstrom (45) als vom Akkuluftstrom (29) getrennter weiterer Kühlluftstrom (44) ausgebildet ist, und die Leistungselektronik (20) im Strömungsweg (43) zwischen der weiteren Zuluftöffnung (40) und dem Kühlluftventilator (25) liegt, und der weitere Kühlluftstrom (44) nach Kühlung der Leistungselektronik (20) dem Kühlluftventilator (25) zugeführt ist,
**dadurch gekennzeichnet, dass** der weitere Kühlluftstrom (44) über eine im Gehäuse (11) ausgebildete innere Strömungsöffnung (42) in die Saugzone (32) des Kühlluftventilators (25) mündet, und dem weiteren Kühlluftstrom (44) über eine im Gehäuse (11) ausgebildete, ergänzende Zuluftöffnung (50) ein Teilluftstrom (38) aus der Gehäuseumgebung (34) zuströmt.

2. Ladegerät nach Anspruch 1,
**dadurch gekennzeichnet, dass** beide Saugluftströme (35, 45) als räumlich voneinander getrennte Kühlluftströme (31, 44) einem gemeinsamen Kühlluftventilator (25) zugeführt sind.

3. Ladegerät nach Anspruch 2,
**dadurch gekennzeichnet, dass** sich die Kühlluftströme (31, 44) über den Kühlluftventilator (25) zu einem gemeinsamen Abluftstrom (39) vereinen.

4. Ladegerät nach Anspruch 1,
**dadurch gekennzeichnet, dass** die Strömungsöffnung (42) im Strömungsweg (43) des weiteren Kühlluftstroms (44) nach der Leistungselektronik (20) im Gehäuseinnenraum (33) vorgesehen ist.

5. Ladegerät nach Anspruch 1,
**dadurch gekennzeichnet, dass** die weitere Zuluftöffnung (40) des weiteren Kühlluftstroms (44) und die ergänzende Zuluftöffnung (50) des Teilluftstroms (38) auf verschiedenen Gehäuseseiten des Gehäuses (11) liegen.

6. Ladegerät nach Anspruch 5 ,
**dadurch gekennzeichnet, dass** die weitere Zuluftöffnung (40) des weiteren Kühlluftstroms (44) oberhalb einer Platine (21) der Leistungselektronik (20) in den Gehäuseinnenraum (33) mündet.

7. Ladegerät nach Anspruch 6,
**dadurch gekennzeichnet, dass** die ergänzende Zuluftöffnung (50) des Teilluftstroms (38) auf über Eck benachbarten Gehäuseseiten des Gehäuses (11) liegt.

8. Ladegerät nach einem der Ansprüche 5 bis 7,
**dadurch gekennzeichnet, dass** eine ergänzende Zuluftöffnung (50) des Teilluftstroms (38) unterhalb einer Platine (21) der Leistungselektronik (20) in den Gehäuseinnenraum (33) mündet.

9. Ladegerät nach Anspruch 1,
**dadurch gekennzeichnet, dass** der Kühlluftventilator (25) unmittelbar vor der Abluftöffnung (23) angeordnet ist.

10. Ladegerät nach einem der Ansprüche 1 bis 9,
**dadurch gekennzeichnet, dass** die Kühlluftströme (31, 44) in voneinander getrennten Gehäusekanälen (30, 52) geführt sind.

## Claims

1. Charger for a battery pack (8), consisting of a housing (11), on which is formed a charging receptacle (1) with outer connecting contacts (4, 5, 6, 7) for electric connection to the battery pack (8), with an electric connection (37) for a supply voltage and with power electronics (20) located between the electric connection (37) and the connecting contacts (4, 5, 6, 7), with a cooling air fan (25) located in the housing (11) and providing a cooling air flow (31) which enters the housing (11) as a suction air flow (35) via an inlet air opening (15) and leaves the housing (11) via an exhaust air opening (23), wherein a battery air flow (29) flowing through the battery pack (8) enters as cooling air flow (31) via the inlet air opening (15) and wherein a further suction air flow (45) enters the housing (11) from the housing environment (34) via a further inlet air opening (40) formed in the housing (11), wherein the further suction air flow (45) is designed as a further cooling air flow (44) separate from the battery air flow (29) and the power electronics (20) lie in the flow path (43) between the further inlet air opening (40) and the cooling air fan (25) and the further cooling air flow (44) is fed to the cooling air fan (25) after cooling the power electronics (20),
**characterised in that** the further cooling air flow (44) terminates into the suction zone (32) of the cooling air fan (25) via an internal flow opening (42) formed in the housing (11) and a part-air flow (38) from the housing environment (34) flows to the further cooling air flow (44) via a supplementary inlet air opening (50) formed in the housing (11).

2. Charger according to claim 1,
**characterised in that** both suction air flows (35, 45) are fed to a common cooling air fan (25) as spatially separated cooling air flows (31, 44).

3. Charger according to claim 2
**characterised in that** the cooling air flows (31, 44) merge into a common exhaust air flow (39) via the cooling air fan (25).

4. Charger according to claim 1,
**characterised in that** the flow opening (42) is provided in the flow path (43) of the further cooling air flow (44) downstream of the power electronics (20) in the housing interior (33).

5. Charger according to claim 1,
**characterised in that** the further inlet air opening (40) of the further cooling air flow (44) and the supplementary inlet air opening (50) of the part-air flow (38) are located on different housing sides of the housing (11).

6. Charger according to claim 5,
**characterised in that** the further inlet air opening (40) of the further cooling air flow (44) terminates into the housing interior (33) above a printed circuit board (21) of the power electronics (20).

7. Charger according to claim 6,
**characterised in that** the supplementary inlet air opening (50) of the part-air flow (38) is located on housing sides of the housing (11) which are adjacent around the corner.

8. Charger according to any of claims 5 to 7,
**characterised in that** a supplementary inlet air opening (50) of the part-air flow (38) terminates into the housing interior (33) below a printed circuit board (21) of the power electronics (20).

9. Charger according to claim 1,
**characterised in that** the cooling air fan (25) is located directly in front of the exhaust air opening (23).

10. Charger according to any of claims 1 to 9,
**characterised in that** the cooling air flows (31, 44) are carried in separate housing passages (30, 52).

## Revendications

1. Chargeur pour une batterie (8), composé d'un boîtier (11) sur lequel est formé un logement de charge (1) avec des contacts de connexion extérieurs (4, 5, 6, 7) pour la connexion électrique à la batterie (8), avec un raccordement électrique (37) pour une tension d'alimentation et avec un système électronique de puissance (20) disposé entre le raccordement électrique (37) et les contacts de connexion (4, 5, 6, 7), avec un ventilateur d'air de refroidissement (25) disposé dans le boîtier (11) avec un courant d'air de refroidissement (31) qui entre dans le boîtier (11) par une ouverture d'arrivée d'air (15) sous la forme d'un courant d'air aspiré (35) et sort du boîtier (11) par une ouverture de sortie d'air (23), un courant d'air de batterie (29) qui traverse la batterie (8) arrivant par l'ouverture d'arrivée d'air (15) sous la forme d'un courant d'air de refroidissement (31) tandis qu'un autre courant d'air aspiré (45) entre dans le boîtier (11), à partir de l'environnement (34) dudit boîtier, par une autre ouverture d'arrivée d'air (40) formée dans le boîtier (11), cet autre courant d'air aspiré (45) ayant la forme d'un autre courant d'air de refroidissement (44), séparé du courant d'air de batterie (29), et le système électronique de puissance (20) se trouvant entre l'autre ouverture d'arrivée d'air (40) et le ventilateur d'air de refroidissement (25), sur la trajectoire d'écoulement (43), et l'autre courant d'air de refroidissement (44) étant amené jusqu'au ventilateur d'air de refroidissement (25) après refroidissement du système électronique de puissance (20),
**caractérisé en ce que** l'autre courant d'air de refroidissement (44) débouche dans la zone d'aspiration (32) du ventilateur d'air de refroidissement (25) par une ouverture d'écoulement intérieure (42) formée dans le boîtier (11), et un courant d'air partiel (38) provenant de l'environnement (34) du boîtier rejoint l'autre courant d'air de refroidissement (44) par une ouverture complémentaire d'arrivée d'air (50) formée dans le boîtier (11).

2. Chargeur selon la revendication 1,
**caractérisé en ce que** les deux courants d'air aspiré (35, 45) sont amenés jusqu'à un ventilateur d'air de refroidissement commun (25) sous la forme de courants d'air de refroidissement (31, 44) séparés l'un de l'autre dans l'espace.

3. Chargeur selon la revendication 2,
**caractérisé en ce que** les courants d'air de refroidissement (31, 44) se réunissent en un courant d'air de sortie commun (39) par l'intermédiaire du ventilateur d'air de refroidissement (25).

4. Chargeur selon la revendication 1,
**caractérisé en ce que** l'ouverture d'écoulement (42) est prévue dans l'espace intérieur de boîtier (33) après le système électronique de puissance (20), sur la trajectoire d'écoulement (43) de l'autre courant d'air de refroidissement (44).

5. Chargeur selon la revendication 1,
**caractérisé en ce que** l'autre ouverture d'arrivée d'air (40) de l'autre courant d'air de refroidissement (44) et l'ouverture complémentaire d'arrivée d'air (50) du courant d'air partiel (38) sont situées sur des côtés différents du boîtier (11).

6. Chargeur selon la revendication 5,
**caractérisé en ce que** l'autre ouverture d'arrivée d'air (40) de l'autre courant d'air de refroidissement (44) débouche dans l'espace intérieur (33) du boîtier au-dessus d'une platine (21) du système électronique de puissance (20).

7. Chargeur selon la revendication 6,
**caractérisé en ce que** l'ouverture complémentaire d'arrivée d'air (50) du courant d'air partiel (38) est située sur des côtés du boîtier (11) qui ont un angle en commun.

8. Chargeur selon l'une des revendications 5 à 7,
**caractérisé en ce qu'**une ouverture complémentaire d'arrivée d'air (50) du courant d'air partiel (38) débouche dans l'espace intérieur (33) du boîtier au-dessous d'une platine (21) du système électronique de puissance (20).

9. Chargeur selon la revendication 1,
**caractérisé en ce que** le ventilateur d'air de refroidissement (25) est disposé juste avant l'ouverture de sortie d'air (23).

10. Chargeur selon l'une des revendications 1 à 9,
**caractérisé en ce que** les courants d'air de refroidissement (31, 44) sont guidés dans des conduits de boîtier (30, 52) séparés.
